# EUROPÄISCHE PATENTSCHRIFT

(11) **EP 0 735 573 B1**
(45) Veröffentlichungstag und Bekanntmachung des Hinweises auf die Patenterteilung: **08.09.2004**
(21) Anmeldenummer: 96101758.9
(22) Anmeldetag: 07.02.1996
(51) Int. Cl.: H01L 21/00

(54) **Be- und Entladestation für Halbleiterbearbeitungsanlagen**
Loading and unloading station for semiconductor treatment installations
Station de chargement et de déchargement pour installations de traitement de semi-conducteurs

(30) Priorität: 28.03.1995 DE 19511024; 15.11.1995 DE 19542646
(43) Veröffentlichungstag der Anmeldung: 02.10.1996
(73) Patentinhaber: BROOKS Automation GmbH, 07745 Jena (DE)
(72) Erfinder: Mages, Andreas, D-07745 Jena (DE); Scheler, Werner, D-07743 Jena (DE); Blaschitz, Herbert, D-81083 München (DE); Schulz, Alfred, D-07747 Jena (DE); Schneider, Heinz, D-07747 Jena (DE)
(74) Vertreter: Beetz & Partner Patentanwälte

(56) Entgegenhaltungen:
- EP-A- 0 452 939
- FR-A- 2 696 429
- US-A- 5 364 219

## Beschreibung

Die Erfindung betrifft ein Verfahren zum Be- und Entladen von Halbleitersubstratscheiben aus einem Transportbehälter in eine Bearbeitungsanlage nach dem Oberbegriff des Patentanspruchs 1. Ferner betrifft die Erfindung eine Halbleiterbearbeitungsanlage gemäß dem Oberbegriff des Patentanspruchs 2. Ein derartiges Verfahren und eine derartige Bearbeitungsanlage sind aus der US-A-5 364 219 bekannt.

Bisher ist es bekannt, zur Beschickung von Halbleiterbearbeitungsanlagen sogenannte SMIF-Boxen als Magazinbehälter mit einem relativ kleinen abgeschlossenen Volumen zu verwenden, in dem Wafermagazine aufbewahrt und transportiert werden können. Die Box ist auf einen Öffnungsmechanismus in einer Einhausung aufsetzbar, die eine oder mehrere Arbeitsstationen staubgeschützt umschließt. Box und Öffnungsmechanismus besitzen einander angepaßte Verschlußelemente, die übereinanderliegend sich gleichzeitig öffnen lassen, so daß außen auf den Verschlußelementen aufliegende Staubpartikel dazwischenliegend eingeschlossen werden, wenn das Wafermagazin zusammen mit den beiden Verschlußelementen in die Einhausung hinein abgesenkt wird. Die Box selbst umschließt die entstehende Öffnung in der Einhausung.

Zur Entnahme der Magazine aus den Transportbehältern und zur Plazierung in der Bearbeitungsanlage dient z. B. eine Be- und Entladeeinrichtung gemäß der DE 43 26 309 C1 oder eine Einrichtung mit anderem Funktionsablauf. Nach der Bearbeitung der Halbleiterscheiben erfolgt der Rücktransport der Magazine in die Transportbehälter.

Die Technik der SMIF-Boxen ist besonders geeignet für Halbleiterscheiben mit herkömmlichem kleineren Durchmesser. Aufgrund der Materialeigenschaften der Halbleiterscheiben werden diese SMIF-Boxen zusammen mit den verwendeten Wafermagazinen mit zunehmendem Durchmesser der Halbleiterscheiben ungeeigneter als Transportbehälter.

Für derartige Halbleiterscheiben sind bereits Transportbehälter bekannt, die gleichzeitig die Magazinfunktion übernehmen. Eine Umladung der Halbleiterscheiben erfolgt einzeln in einer Ebene parallel zur Oberfläche der Halbleiterscheiben, wobei der Transportbehälter mit einem in seiner wesentlichen Ausdehnung senkrecht zur Ebene der Umladung gerichteten Behälterdeckel verschließbar ist. Der Behälterdeckel wird somit im Gegensatz zur SMIF-Box nicht nach unten, sondern seitlich entfernt bzw. eingesetzt.
Da die Transportbehälter von einem Raum mit niedrigen Anforderungen an die Reinheit umgeben sind und umladbare Magazine, wie sie bei einer SMIF-Lösung Anwendung finden, fehlen, ist sowohl eine Bestückung von Halbleiterbearbeitungsanlagen aus diesen Transportbehältern als auch ein Rücktransport aus derartigen Anlagen in die Transportbehälter problematisch. Das bestehende Problem wird außerdem dadurch erschwert, daß unter Umständen aus einer größeren Anzahl von Transportbehältern wahlweise eine Umladung zu gewährleisten ist und die Behälter selbst vom Bedienpersonal ergonomisch vorteilhaft zugeführt und entnommen werden müssen.

Aus der EP 542 793 B1 ist eine Anordnung zum Lagern, Transportieren und Einschleusen von Substraten bekannt, bei der eine Kassette mit seitlicher Verschlußkappe gegenüber einem Beladeschlitz angeordnet wird. Mit einer Hubplatte, die ein Paket von gestapelten Kassetten aufnehmen kann, werden die Kassetten nacheinander in die Beladeposition gebracht. Ist diese Position erreicht, wird die Verschlußklappe durch Verschwenken um eine Kante geöffnet und mit einer aus der Kassette ausfahrbaren Schublade wird die Substratscheibe in den Reinraum geschleust. Ein aus dem Beladeschlitz austretender Luftstrom wirkt dem Eindringen von Partikeln in den Reinraum dadurch entgegen, daß dieser durch einen freigelassenen Abstand zwischen einer vorspringenden Dichtung und der Kassette hindurchtritt.

In der eingangs zitierten US-A-5 364 219 ist ein Übergabesystem von Halbleitersubstratscheiben aus einem Transportbehälter in mehrere Stationen einer Halbleiterbearbeitungsanlage beschrieben, bei dem mehrere nebeneinander angeordnete Bearbeitungsstationen von einer auf Laufschienen verfahrbaren Transporteinheit angefahren werden. Diese Transporteinheit enthält eine Vakuumkammer mit einer darin angeordneten Handhabungseinrichtung sowie eine mit der Vakuumkammer über eine Öffnung verbundene Speicherkammer mit übereinanderliegenden Fächern zur Halterung von Halbleitersubstratscheiben. In der den Bearbeitungsstationen zugewandten Stirnwand der Vakuumkammer ist eine Durchgriffsöffnung vorgesehen, die durch eine Platte dicht verschlossen ist. Jede Bearbeitungsstation weist eine Reinraumkammer mit einem Halter für eine zu bearbeitende Substratscheibe und mit einer Durchgriffsöffnung in der der Transporteinheit zugewandten Stirnwand auf. Diese Durchgriffsöffnung ist normalerweise durch eine Dichtplatte verschlossen. Jede Bearbeitungsstation enthält einen außerhalb ihrer Vakuumkammer angeordneten Betätigungsmechanismus zum Öffnen und Schließen der beiden Durchgriffsöffnungen. Bei dicht an die 8earbeitungsstation herangefahrener Transporteinheit gelangt deren Platte mit einem Kupplungsglied des in diesem Zustand in einem Zwischenraum zwischen der Bearbeitungsstation und der angekoppelten Transporteinheit befindlichen Betätigungsmechanismus in formschlüssigen Eingriff. Ein Druckmittelzylinder bewegt das Kupplungsglied zusammen mit den beiden Verschlußplatten geradlinig parallel zu den beiden Stirnwänden unter Beibehaltung eines Zwischenabstands. Nach Verschieben der beiden Verschlußplatten in ihre untere Öffnungsstellung erfolgt das Umladen einer Substratscheibe aus der Speicherkammer in die Bearbeitungsstation, indem die in der Transporteinheit angeordnete Handhabungseinrichtung durch die beiden voneinander beabstandeten Durchgriffsöffnungen hindurchgreift.

Aufgabe der Erfindung ist es, eine reinraumgerechte Bestückung von Halbleiterbearbeitungsanlagen aus Transportbehältern zu gewährleisten, die selbst als Magazine für scheibenförmige Objekte dienen und die seitlich zu öffnen sind. Ein Umladen soll wahlweise auch aus einer größeren Anzahl derartiger Transportbehälter möglich sein, wobei ein Wechseln der Transportbehälter unter ergonomisch vorteilhaften Bedingungen zu erfolgen hat.

Diese Aufgabe wird erfindungsgemäß durch die im Verfahrensanspruch 1 angegebenen Maßnahmen und bei einer Halbleiterbearbeitungsanlage durch die Merkmale des Patentanspruchs 2 gelöst.

Bei der Be- und Entladestation der erfindungsgemäßen Halbleiterbearbeitungsanlage mit einer verschließbaren Beschickungsöffnung erfolgt nach dem Entfernen eines Verschlusses ein Umladen von scheibenförmigen, in einem Transportbehälter untergebrachten Objekten, wobei der Transportbehälter mit einem in seiner wesentlichen Ausdehnung senkrecht zur Ebene der Umladung gerichteten Behälterdeckel versehen ist. Der Transportbehälter wird zum Umladen der scheibenförmigen Objekte mit seinem Behälterdeckel fest an den Verschluß angekoppelt und es erfolgt ein gleichzeitiges Öffnen der Beschickungsöffnung und des Transportbehälters durch eine gemeinsame Abnahme des Behälterdeckels und des Verschlusses in die Halbleiterbearbeitungsanlage. Das Umladen ist mit einem Durchgriff einer in der Halbleiterbearbeitungsanlage angeordneten Handhabungseinrichtung durch die Beschickungsöffnung in den Transportbehälter verbunden.

Der Transportbehälter kann zur Ankopplung an den Verschluß auf einer horizontal verstellbaren und mit Mitteln zum Ausrichten und Befestigen des Transportbehälters versehenen ersten Plattform abgestellt werden.

Die Plattform kann zwischen mindestens zwei übereinanderliegenden Ebenen verstellbar sein, von denen eine der Bestückung mit einem Transportbehälter in einer ergonomischen Höhe und jede andere zur Be- und Entladung der Halbleiterbearbeitungsanlage dient.

Vorteilhafterweise kann zur Aufnahme mindestens eines weiteren Transportbehälters eine entsprechende Anzahl von weiteren, horizontal verstellbaren und mit Mitteln zum Ausrichten und Befestigen des Transportbehälters versehenen Plattformen vorgesehen werden. Von den Plattformen dient abwechselnd mindestens eine zur Ankopplung eines Transportbehälters an den Verschluß, währenddessen die anderen zum Transportbehälterwechsel frei sind.

Es ist auch von Vorteil, wenn zum Transportbehälterwechsel ein Speicher vorgesehen ist, in dem ein Greifer einen wahlfreien Zugriff in übereinander angeordnete Speicherfächer besitzt und eine Beladeöffnung mit einer Transportbehälteraufnahme zur manuellen Bestückung mit Transportbehältern dient. Zum Umsetzen der Transportbehälter zwischen der Transportbehälteraufnahme, den Speicherfächern und der Plattform ist ein der Größe eines Transportbehälters entsprechender Raum benachbart zu den Speicherfächern freigelassen. Die Transportbehälteraufnahme sollte zur Bestückung durch die Beladeöffnung hindurch ausfahrbar sein.

Ferner ist es von Vorteil, wenn der Verschluß zur Erzeugung des Kraftschlusses mit dem Behälterdeckel Vakuumsaugeinrichtungen aufweist und mit Elementen zur Ausrichtung gegenüber dem Behälterdeckel versehen ist, die vor der Herstellung des Kraftschlusses wirksam sind.
Zum Öffnen des Transportbehälters ragen aus dem Verschluß Schlüssel zum Betätigen von Verriegelungselementen im Behälterdeckel heraus, für die im Behälterdeckel passende Schlüssellöcher vorgesehen sind und mit denen der Verschluß und der Behälterdeckel zusätzlich zum Kraftschluß gesichert sind. Zum Ausgleich von Differenzen bei der Annäherung zwischen dem Verschluß und dem Behälterdeckel können die Ausrichtelemente und die Schlüssel in einer Richtung senkrecht zur Ebene der Umladung federnd gehaltert sein.

Vorteilhaft ist es auch, wenn die Beschickungsöffnung in ein Schild eingearbeitet ist, das gemeinsam mit dem angekoppelten Transportbehälter zum Umladen der scheibenförmigen Objekte in einer Richtung senkrecht zur Ebene der Umladung nach indizierten Positionen gegenüber der Handhabungseinrichtung verstellbar ist.
Dadurch ist es möglich, mit einem einzigen Fahrstuhl sowohl die Bewegung zwischen den verschiedenen Ebenen als auch die Indexbewegungen auszuführen.

Möglich ist es ist jedoch auch, die Handhabungseinrichtung zum Umladen der scheibenförmigen Objekte in einer Richtung senkrecht zur Ebene der Umladung nach indizierten Positionen verstellbar auszubilden.

Mit der beschriebenen Lösung gemäß der Erfindung können Transportbehälter der beschriebenen Art ohne negative Beeinflussung der Reinraumbedingungen innerhalb der zu beschickenden Halbleiterbearbeitungsanlage eingesetzt werden. Halbleiterscheiben mit einer Größe von 300 mm können problemlos gehandhabt werden.
Staubpartikel, die sich beim Ankoppeln an den Verschluß auf dem Behälterdeckel befinden, werden zwischen den kraftschlüssig verbundenen Oberflächen sicher eingeschlossen.

Die Erfindung soll nachstehend anhand der schematischen Zeichnung näher erläutert werden. Es zeigen:
- Fig. 1: eine Prinzipdarstellung einer Be- und Entladestation mit einem verschiebbaren Schild in Seitenansicht
- Fig. 2: die Be- und Entladestation in Draufsicht
- Fig. 3: die Be- und Entladestation in Vorderansicht
- Fig. 4: eine Be- und Entladestation in perspektivischer Darstellung mit einem Transportbehälter im angekoppelten und geöffneten Zustand
- Fig. 5: teilweise im Schnitt eine erste Einrichtung zum Öffnen und Schließen eines Verschlusses im geschlossenen Zustand
- Fig. 6: die Einrichtung gemäß Fig. 5 im geschlossenen Zustand in Seitenansicht
- Fig. 7: in perspektivischer Darstellung eine Be- und Entladestation mit einer weiteren Plattform und weiterem Transportbehälter
- Fig. 8: die Be- und Entladestation gemäß Fig. 7 von der Seite
- Fig. 9: eine Seitenansicht eines Speichers für Transportbehälter
- Fig. 10: der Speicher in perspektivischer Darstellung und teilweise geöffnet
- Fig. 11: ein geöffneter Speicher in Draufsicht
- Fig. 12: einen Verschluß und einen Behälterdeckel
- Fig. 13: das vororientierte Koppeln des Verschlusses und des Behälterdeckel
- Fig. 14: eine erste Variante eines geklemmten und teilweise aufgebrochenen Transportbehälters
- Fig. 15: einen Schnitt A-A durch den Transportbehälter gemäß Fig. 14
- Fig. 16: eine zweite Variante eines geklemmten und teilweise aufgebrochenen Transportbehälters
- Fig. 17: einen Schnitt B-B durch den Transportbehälter gemäß Fig. 16
- Fig. 18: einen Teil einer Be- und Entladestation mit einer zweiten Einrichtung zum Öffnen und Schließen eines Verschlusses in Vorderansicht
- Fig. 19: die Einrichtung gemäß Fig. 18 in Draufsicht

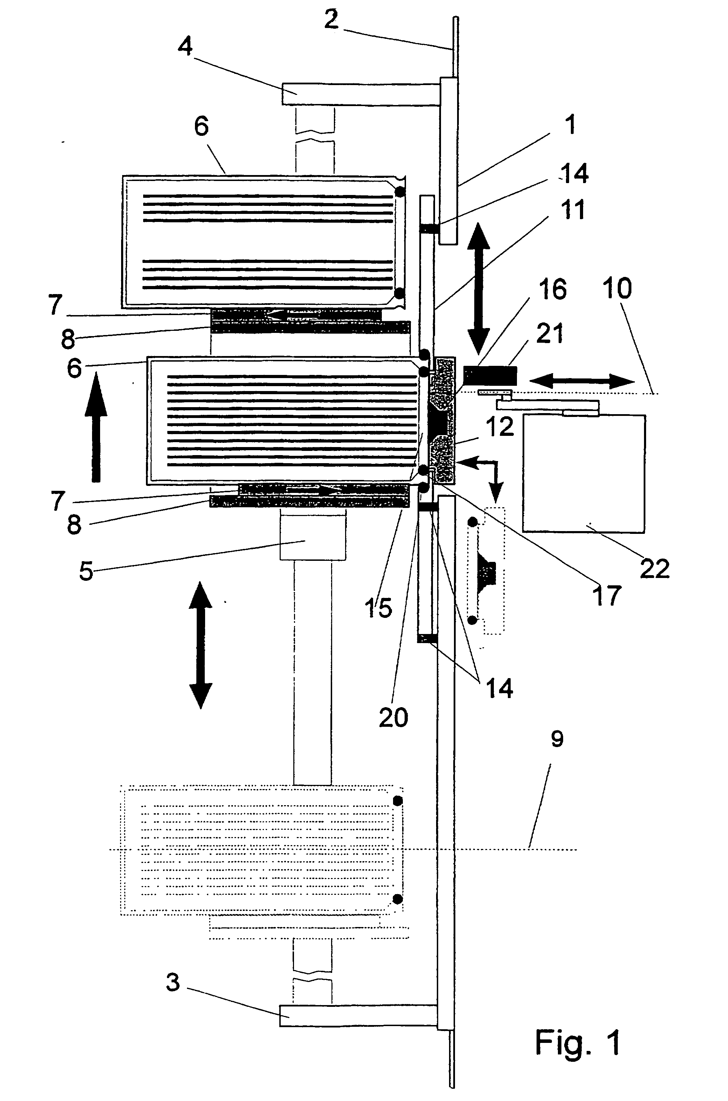

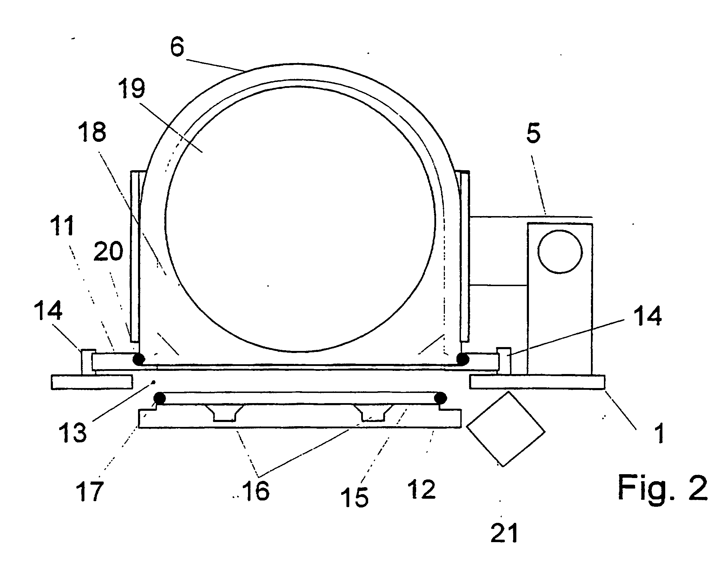

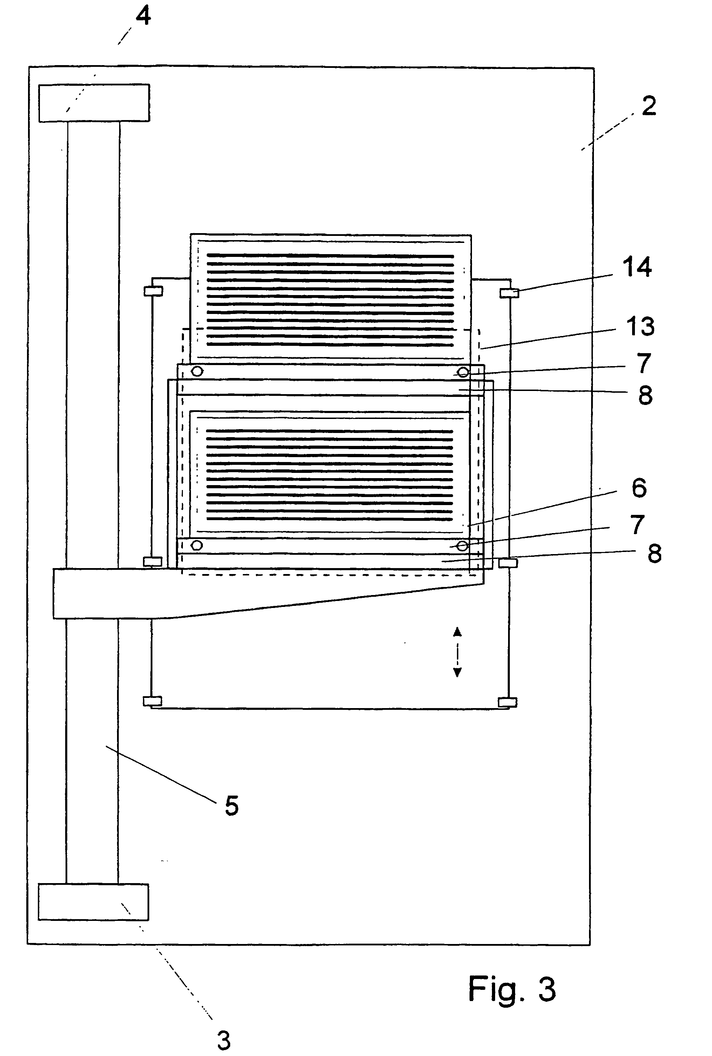

In den Figuren 1 bis 3 trägt ein Rahmen 1, der mit einem Wandelement 2 fest verbunden ist mit zwei abgewinkelten Rahmenelementen 3, 4 einen Fahrstuhl 5.
Als Aufnahmeelemente für Transportbehälter 6, die in ihrer Form und Ausstattung in gewissen Grenzen verschieden gestaltet sein können, dienen Plattformen 7, die in einer an dem Fahrstuhl 5 befestigten Führung 8 horizontal in Richtung des Wandelementes 2 verstellbar sind. Die Plattformen 7, deren Anzahl nicht auf die hier dargestellten beschränkt ist, sind mit dem Fahrstuhl 5 zwischen mindestens zwei übereinanderliegenden Ebenen 9 und 10 verfahrbar. Während die Ebene 9 in einer ergonomisch günstigen Höhe zum Bestücken der Plattformen 7 liegt, erfolgt in der Ebene 10 die Be- und Entladung der Halbleiterbearbeitungsanlage. Dafür ist in einem Schild 11 eine, durch einen Verschluß 12 verschließbare Beschickungsöffnung 13 eingearbeitet. Das Schild 11 ist in einer Richtung senkrecht zur Ebene 10 entlang der Wandung 2, geführt durch Führungselemente 14, verstellbar und besitzt eine Abdichtfunktion gegenüber einer Öffnung im Wandelement 2. Durch Horizontalverstellung jeweils einer der Plattformen 7 in Richtung des Wandelementes 2 wird ein Transportbehälter 6 mit seinem Behälterdeckel 15 an den Verschluß 12 kraftschlüssig angekoppelt. Zu diesem Zweck sind in den Verschluß 12 Saugelemente 16 eingearbeitet, von denen eine nichtdargestellte Schlauchverbindung zu einer Vakuumquelle besteht.
Der in den Transportbehälter 6 eingeschobene und verriegelte Behälterdeckel 15 ist von einer Dichtung 17 umschlossen, durch die eine Abdichtung gegenüber der umschließenden Wand gewährleistet ist. Nachdem die kraftschlüssige Verbindung hergestellt ist, erfolgt eine Entriegelung und der Verschluß 12 kann zusammen mit dem Behälterdeckel 15 in der durch einen abgewinkelten Pfeil dargestellten Weise in die Halbleiterbearbeitungsanlage abgenommen werden.
Jeder der Transportbehälter 6 besitzt übereinanderliegende, durch fächerbildende Vorsprünge 18 gebildete Fächer zur Aufnahme scheibenförmiger Objekte 19.
Für deren Umladung durch die Beschickungsöffnung 13 in der Ebene 10 ist es nach der Ausführung gemäß Fig. 1 erforderlich, den Transportbehälter 6 in seiner Höhenlage entsprechend einzustellen. Zu diesem Zweck ist der Transportbehälter 6 nach außen zusätzlich durch eine Dichtung 20 gegen das Schild 11 abgedichtet, das wiederum mit einer vertikalen Indexbewegung, zu deren Ausführung ebenfalls der Fahrstuhl 5 dient, mitgeführt wird. Durch die Abdichtfunktion des Schildes 11 bleiben die Reinraumbedingungen innerhalb der Halbleiterbearbeitungsanlage ungestört.
Ein Indexsensor 21 erfaßt zur Indexierung sowohl die Vorsprünge 18 als auch die scheibenförmigen Objekte 19 bei der Höhenverstellung des Transportbehälters 6.
Durch eine im Reinraumbereich der Halbleiterbearbeitungsanlage angeordnete Handhabungseinrichtung 22 erfolgt das Umladen in der Ebene 10 mit einem Durchgriff durch die Beschickungsöffnung 13.

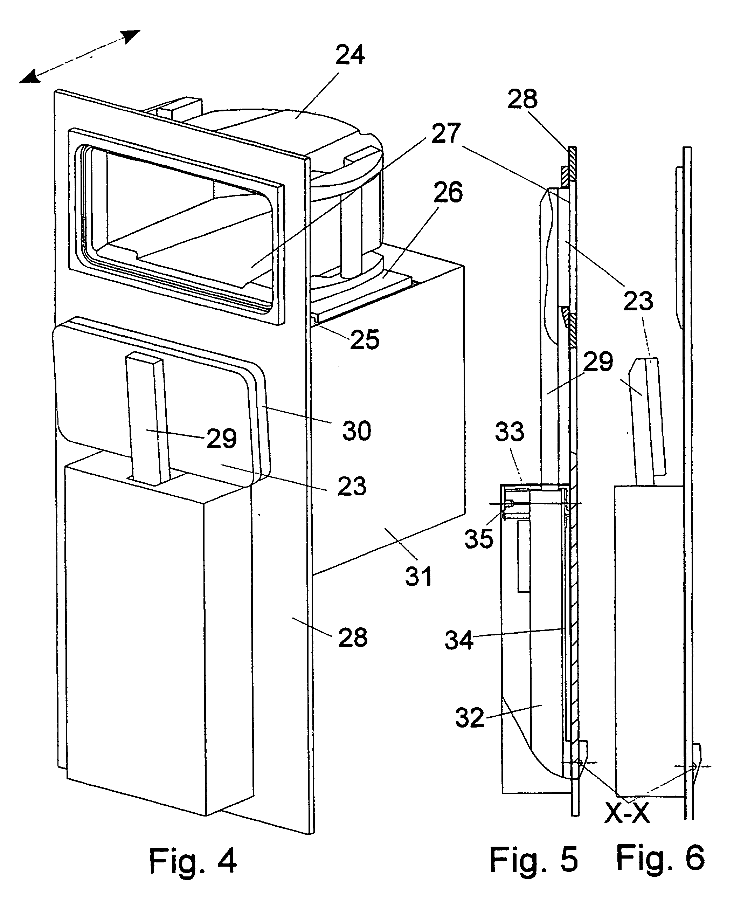

Bei der in Fig. 4 dargestellten Be- und Entladestation kommt eine, in Fig. 5 noch näher dargestellte Einrichtung zum Öffnen und Schließen eines Verschlusses 23 zum Einsatz. Ein bereits geöffneter Transportbehälter 24 ist auf einer, von einer feststehenden Platte 25 getragenen, in Pfeilrichtung horizontal verschiebbaren Plattform 26 abgestellt und steht mit einer Beschickungsöffnung 27 in einem Wandelement 28 in Verbindung.
Der Verschluß 23 ist an einem höhen- und gegen das Wandelement 28 verstellbaren Arm 29 befestigt und trägt einen durch Kraftschluß angekoppelten Behälterdeckel 30. In einem Gehäuse 31 sind Antriebs- und Steuerelemente der Be- und Entladestation untergebracht.

Gemäß Fig. 5 sind sowohl zur Höhenverstellung als auch zur Verstellung des Armes 29 gegen das Wandelement 28 Hubzylinder 32 bzw. 33 vorgesehen, wobei der an einer Trägerplatte 34 befestigte Hubzylinder 32 durch die Wirkung des Hubzylinders 33 gemeinsam mit der Trägerplatte 34 um eine Achse X-X bis zu einem Anschlag 35 schwenkbar ist.

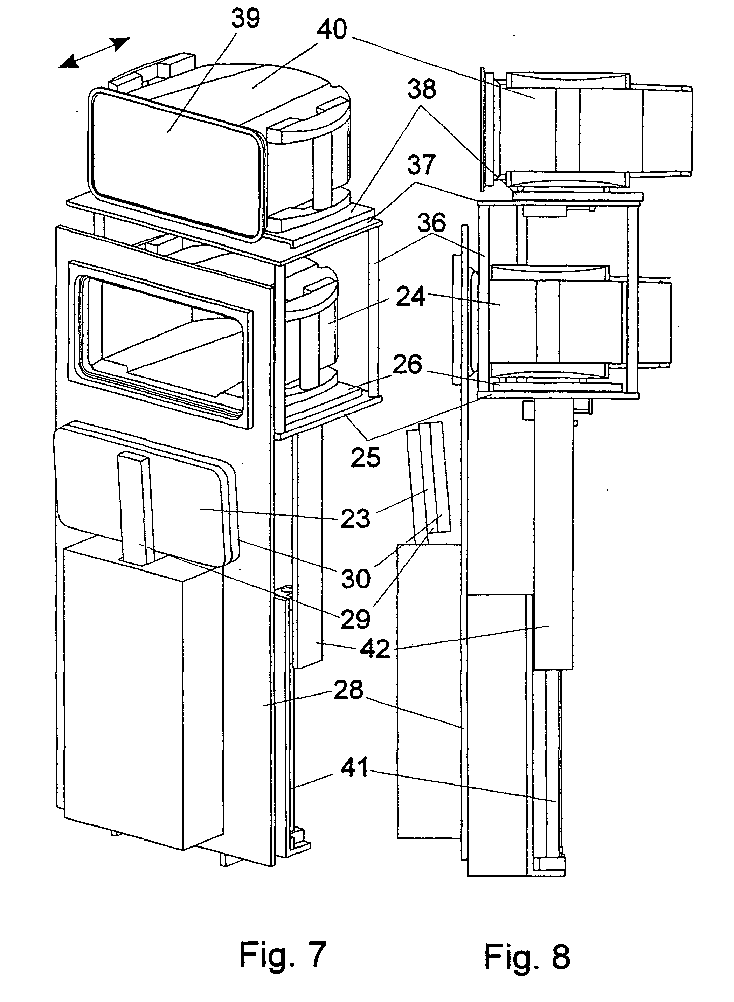

Im Unterschied zur Ausführungsform nach Fig. 4, die lediglich die Aufnahme von einem Transportbehälter 24 vorsieht, tragen in Fig. 7 an der Platte 25 befestigte Stützen 36 eine weitere feststehende Platte 37, auf der eine zweite, in Pfeilrichtung horizontal verschiebbare Plattform 38 befestigt ist. Ein weiterer, durch einen Transportbehälterdeckel 39 verschlossener Transportbehälter ist mit 40 bezeichnet.
Beide Plattformen 26, 37 sind über einen, mit der Platte 25 verbundenen und durch einen Antrieb 41 anheb- und absenkbaren Trägerarm 42 vertikal verstellbar.
Während eine der Plattformen 26, 37 zur Ankopplung eines Transportbehälters 24 oder 38 an den Verschluß 23 dient, steht die andere zum Transportbehälterwechsel zur Verfügung.
Selbstverständlich ist die vertikale Verstellbarkeit, wie sie in Fig. 7 und 8 dargestellt ist, durch einen Fachmann ohne weiteres auch bei einer Ausführung gemäß Fig. 4 anwendbar, indem nur ein Transportbehälter zwischen zwei Ebenen verstellbar ist. Ebenso kann die Anzahl der aufnehmbaren Transportbehälter, angepaßt an entsprechende Anforderungen, erweitert werden.

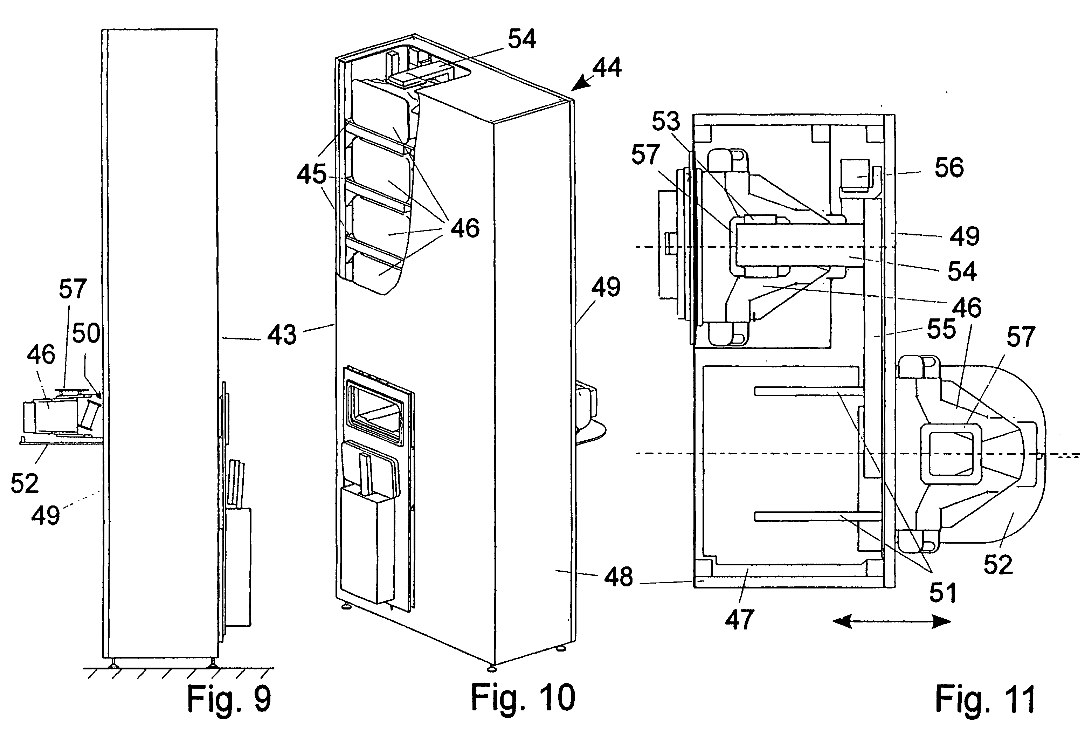

Zum Transportbehälterwechsel von Be- und Entladeeinrichtungen nach den Figuren 4, 7 und 8 kann ein Speicher Anwendung finden, wie er in den Figuren 9 bis 11 näher beschrieben ist.

Die Be- und Entladeeinrichtung ist in eine Wand 43 eines Gehäuses 44 integriert, in dem übereinander angeordnete Speicherfächer 45 zur Aufnahme von Transportbehältern 46 vorgesehen sind. Der Speicher im vorliegenden Ausführungsbeispiel ist dabei so aufgebaut, daß unabhängig davon, welche Be- und Entladeeinrichtung verwendet wird, die Speicherfächer 45 oberhalb der Plattformen der Be- und Entladeeinrichtung angeordnet sind.
Wesentlich für einen wahlfreien Zugriff auf die Transportbehälter 46 in den Speicherfächern 45 ist ein der Größe der Transportbehälter 46 entsprechender freigelassener Raum 47 zwischen den Speicherfächern 45 und einer Wand des Gehäuses 44, die nicht identisch mit der Wand 43 ist. Die Wand, zu der der Raum freizulassen ist, richtet sich nach dem zur Verfügung stehenden Aufstellplatz für den Speicher.
In der vorliegenden Ausführung liegt der Freiraum zu einer Wand 48, die zur Wand 43 mit der Be- und Entladeeinrichtung benachbart ist, wodurch ein Speicher mit geringer Tiefe entsteht.
In ergonomischer Höhe ist in die zur Wand 43 gegenüberliegende Wand 49 eine verschließbare Beladeöffnung 50 eingearbeitet, die neben einer auf Führungen 51 ausfahrbaren Transportbehälteraufnahme 52 zur manuellen Bestückung des Speichers mit den Transportbehältern 46 dient.

Entsprechend der Fig. 11 ist zum Umsetzen der Transportbehälter 46 ein vertikal und horizontal verfahrbarer Greifer 53 vorhanden, der mit einem Ausleger 54 an einem Horizontalantrieb 55 befestigt ist. Der Horizontalantrieb 55 wiederum steht mit einem Fahrstuhl 56 in Verbindung.
Im Deckbereich weisen die Transportbehälter 46 einen Griff 57 zum automatischen Erfassen mit dem Greifer 53 auf. Oberhalb eines jeden Transportbehälters 46 ist soviel Platz gelassen, daß der Ausleger 54 mit dem Greifer 53 zum Umsetzen wirksam werden kann.
Nachdem ein Transportbehälter 46 erfaßt ist, wird er horizontal aus dem Speicherfach 45 in den freigelassenen Raum 47 und anschließend vertikal bis zu einer Ebene transportiert, die der ergonomischen Höhe zur manuellen Bestückung des Speichers oder einer Ebene zur Bestückung einer Plattform der Be- und Entladeeinrichtung entspricht. Ist die Ebene erreicht, wird der Transportbehälter 46 an die Plattform oder die eingefahrene Transportbehälteraufnahme 52 übergeben. (Fig. 11 zeigt die ausgefahrene Position der Transportbehälteraufnahme 52.) Eine Umsetzung in umgekehrter Richtung erfolgt analog.

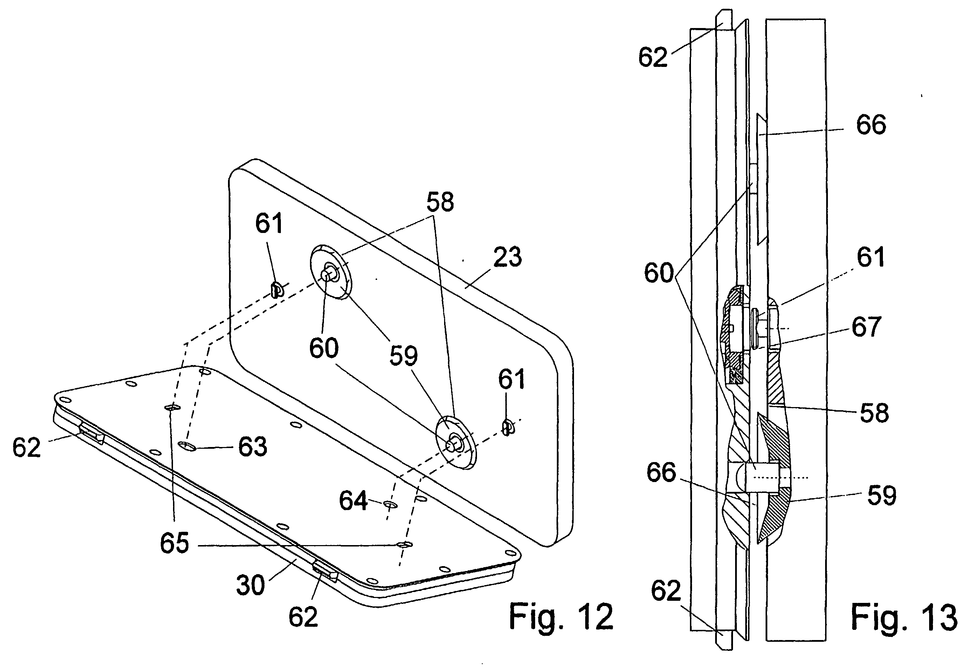

Gemäß den Figuren 12 und 13 weist der Verschluß 23 aus Bohrungen 58 austretende Ansaugelemente 59 auf, in deren Zentrum Ausrichtelemente in Form von Stiften 60 angeordnet sind. Desweiteren sind im Verschluß 23 Schlüssel 61 mit einem Doppelbart zur Betätigung von Verriegelungselementen 62 im Behälterdeckel 30 vorgesehen. Passend zu den Stiften 60 sind im Behälterdeckel 30 ein Langloch 63 und eine Bohrung 64 sowie für die Schlüssel 61 entsprechende Schlüssellöcher 65 eingearbeitet. Zur vororientierenden Ausrichtung des Behälterdeckels 30 zum Verschluß 23 beim Ankoppelvorgang überragen die Stifte 60 die Ansaugelemente 59, so daß diese zuerst in das Langloch 63 bzw. in die Bohrung 64 eingreifen. Anschließend tauchen die Schlüssel 61 in die Schlüssellöcher 65 ein, wobei die Ansaugelemente 59 mit ihren vorstehenden Lippen 66 auf der Oberfäche des Behälterdeckels 30 aufliegen. Bei dem nunmehr einsetzenden Ansaugvorgang, bei dem die Lippen 66 vollständig in die im Durchmesser groß genug ausgebildeten Bohrungen 58 zurückweichen, werden die Oberflächen des Verschlusses 23 und des Behälterdeckels 30 kraftschlüssig fest miteinander verbunden und anhaftende Partikel dazwischen eingeschlossen. Durch Drehung der Schlüssel 61 wird ein im Inneren des Behälterdeckels 30 vorhandener Mitnehmer 67 betätigt, der die Verriegelungselemente 62 öffnet. Der Verschluß 23 kann zusammen mit dem Behälterdeckel 30 in die Halbleiterbearbeitungsanlage abgenommen werden, so daß eine Schleuse entsteht.
Mit den verwendeten Schlüsseln 61 ist außer der Öffnerfunktion ein weiterer positiver Effekt verbunden. Nach dem Verdrehen der in die Schlüssellöcher 65 eingeführten Schlüssel 61 wird der Behälterdeckel 30 durch das Hintergreifen der Schlüssellöcher 65 mit dem Doppelbart auch dann noch gehalten, wenn es zu einem Vakuumausfall bei den Ansaugelementen 59 kommt. Die sich wieder ausdehnenden Lippen 66 der Ansaugelemente 59 bleiben dicht auf der Oberfläche des Behälterdeckels 30 liegen, so daß bei Wiederverfügbarkeit des Vakuums beide Oberflächen sofort wieder fest aneinandergepreßt werden.
Zur Vermeidung von Verspannungen beim Ankoppeln sind die Ausrichtelemente und die Schlüssel 61 zusätzlich innerhalb des innen hohlen Verschlusses 23 federnd gehaltert.

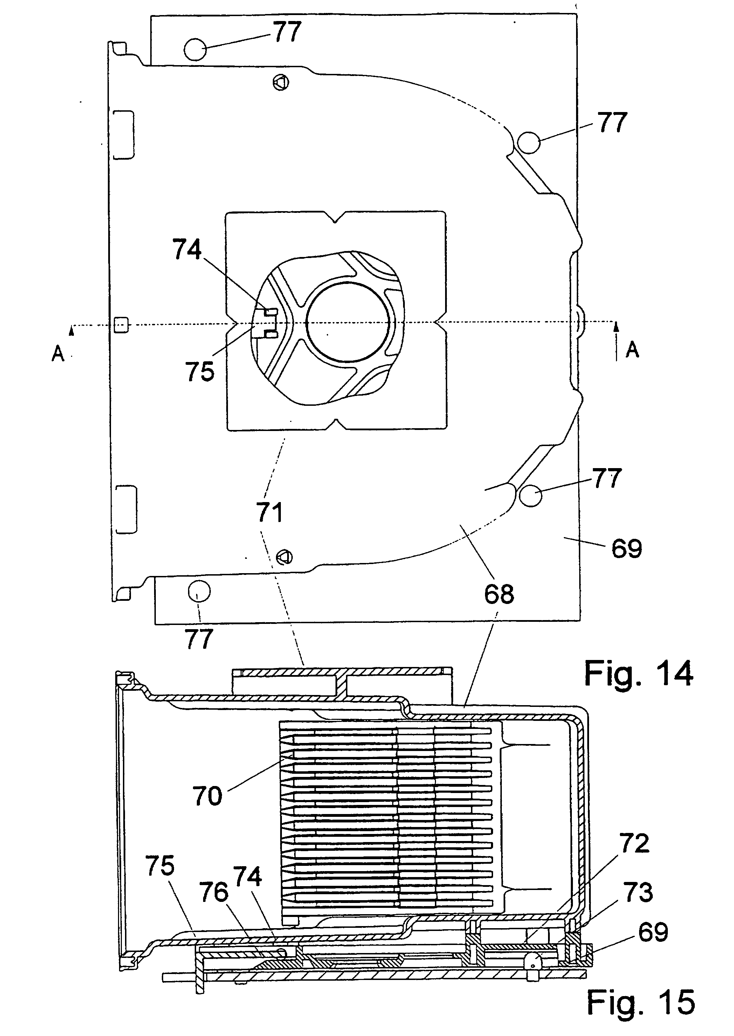

Weitere, für die Ankopplung des Transportbehälters vorteilhafte Maßnahmen sind den Figuren 14 bis 17, zu entnehmen.
Das betrifft zum einen das ausgerichtete Abstellen des Transportbehälters auf der Plattform. Zum anderen werden beim Vorgang des Öffnens, wie er unter anderem in Verbindung mit der Figurenbeschreibung von 12 und 13 erläutert wurde, Kräfte auf den Transportbehälter wirksam, die zur Vermeidung von Störungen des Be- und Entladeprozesses ausgeglichen werden müssen.

In den Figuren 14 und 15 ist ein Transportbehälter 68 auf einer Plattform 69 abgestellt, die in ihrer Funktion den Plattformen in den bereits beschriebenen Figuren entspricht.
Der Transportbehälter 68 besitzt in Inneren Fächer 70 zur Aufnahme der scheibenförmigen Objekte. Im Deckbereich ist, wie bereits bei dem Transportbehälter in Fig. 11, ein hier mit 71 bezeichneter Griff für einen automatisch arbeitenden Greifer angebracht. Im Boden des Transportbehälters 68 und in der Plattform 69 sind zum orientierten Abstellen zueinander passend gestaltete Ausrichtelemente in Form von Nuten 72 und eingreifenden Stiften 73 in einer Dreipunktformation vorgesehen. Eine federnde Rolle 74 an einem, gegenüber der Plattform 69 feststehenden Andruckarm 75 gleitet während der horizontalen Ankoppelbewegung des Transportbehälters 68 über einen am Boden mit einem Abstand befestigten abgeschrägten Steg 76 und fixiert den Transportbehälter 68.
Soll der Transportbehälter 68 manuell auf die Plattform 69 aufgesetzt werden, sind sichtbare Orientierungsstifte 77 hilfreich.

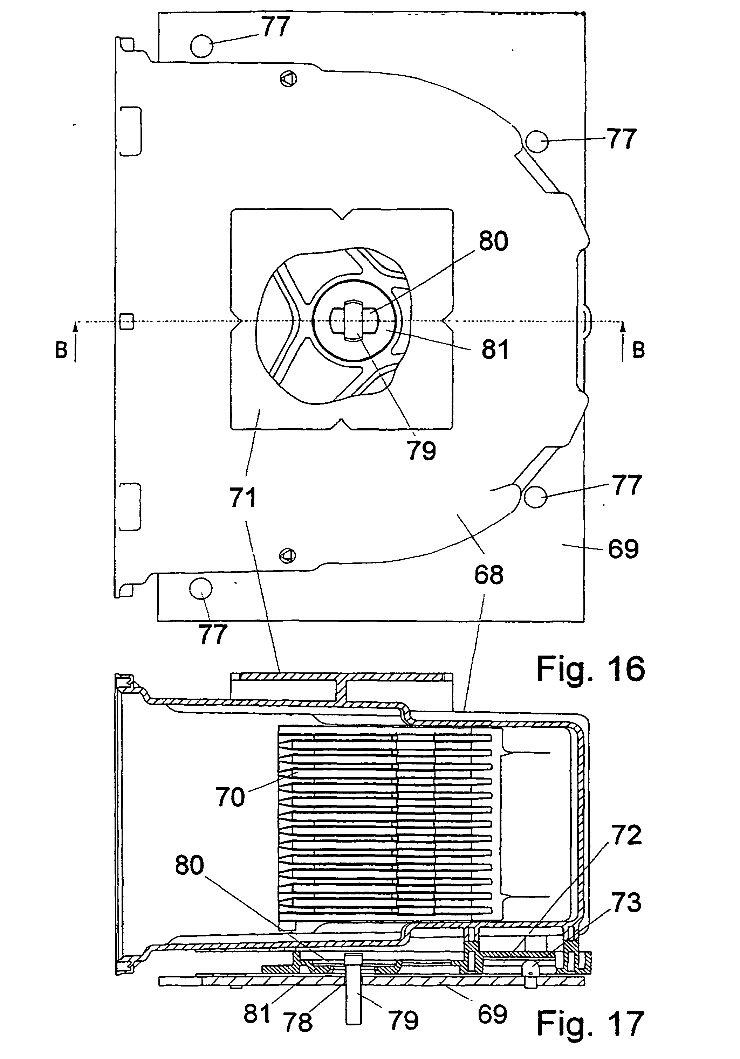

Eine weitere Art der Fixierung eines Transportbehälters auf der Plattform ist mit einer Lösung gemäß den Figuren 16 und 17 gegeben.
Ein durch eine Bohrung 78 in der Plattform 69 hindurchgeführter Schlüssel 79 taucht beim Aufsetzen des Transportbehälters 68 durch ein Schlüsselloch 80, das in eine am Boden mit einem Abstand befestigte Platte 81 eingearbeitet ist und hintergreift diese nach einer Schließbewegung.

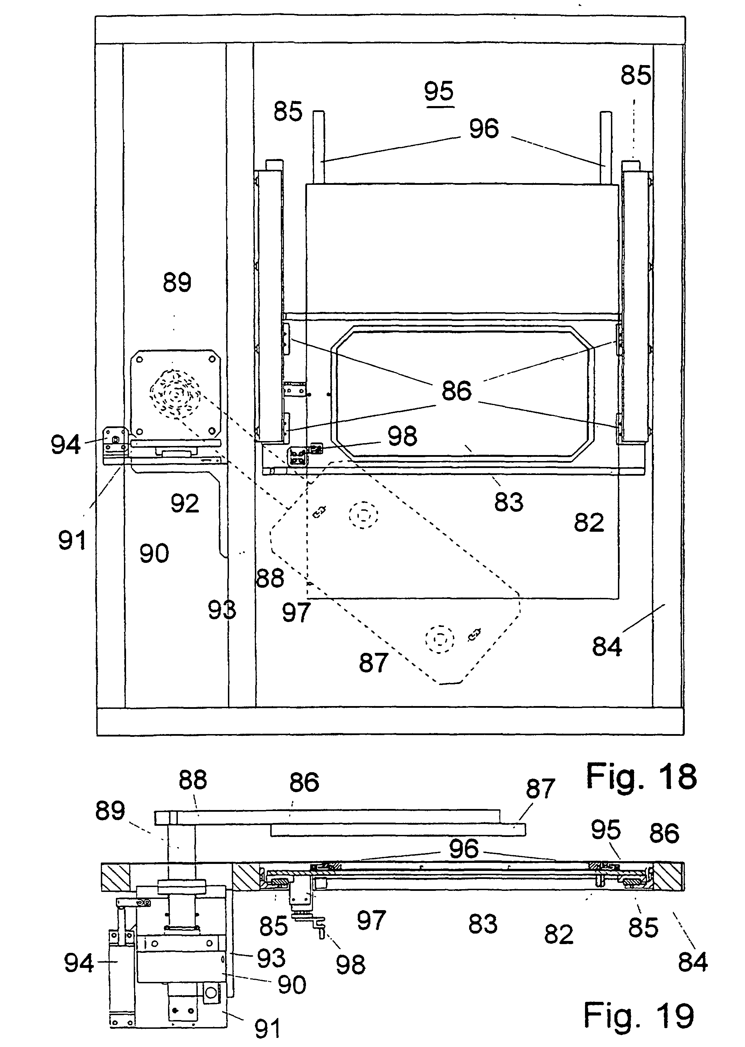

Gemäß den Figuren 18 und 19 wird eine weitere Einrichtung zum Öffnen und Schließen eines Verschlusses beschrieben, mit der die Be- und Entladeeinrichtung in ihrer Tiefe verkürzt werden kann. Dieses Ausführungsbeispiel benutzt wie das der Figuren 1 bis 3 ein Schild, in das die Beschickungsöffnung eingearbeitet ist. Es ist aber auch möglich, in Zusammenhang mit dieser Einrichtung eine feststehende Beschickungsöffnung zu verwenden. Der Übersicht halber wurde, obwohl die Beschickungsöffnung geöffnet ist, ein auf einer Plattform abgestellter, angekoppelter Transportbehälter nicht dargestellt.

Das Schild mit der Beschickungsöffnung, hier mit 82 und 83 bezeichnet, wird von einem Rahmen 84 über Führungen 85 und Führungsschlitten 86 getragen. Ein Verschluß 87 für die Beschickungsöffnung 83 ist über einen Arm 88 an einer Rotorachse 89 befestigt, die von einem Rotationsantrieb 90 angetrieben wird. Der Rotationsantrieb 90 ist auf eine Aufnahmeplatte 91 aufgeschraubt, die durch eine Horizontalführung 92 auf einer, mit dem Rahmen 84 fest verbundenen Trägerplatte 93 in Richtung der Umladung verschiebbar ist. Zur Verschiebung dient ein geeigneter Antrieb 94, wie z. B. ein Pneumatikantrieb.
Das Schild 82 ist vorteilhafterweise im Bereich der Beschickungsöffnung 83 verstärkt ausgebildet und und überdeckt eine Öffnung in einer Wand 95, an der der Rahmen 84 befestigt ist. Die nicht sichtbare Öffnung besitzt eine vertikale Ausdehnung, deren Größe eine Vertikalverstellung der Beschickungsöffnung 83 über die gesamte Öffnungshöhe gestattet. Dadurch kann mit einer fest angeordneten Handhabungseinrichtung in verschiedene, indexierte Ebenen eines angekoppelten Transportbehälters durch die Beschickungsöffnung hindurch zugegriffen werden.
Eine abdichtende Funktion bei der Verstellung des Schildes 82 besitzt ein Labyrinth 96, von dem ein Teil benachbart zu der Öffnung in der Wand 95 und das andere Teil am verstellbaren Schild 82 befestigt ist,
Zum Ankoppeln des Transportbehälters ist an dem Schild 82 ein mit einem Pneumatikzylinder 97 betätigbarer Mitnehmer 98 für die Plattform befestigt. Nachdem die Plattform mit Transportbehälter bis in den Bereich der Ankopplung bewegt worden ist, wird diese durch den Mitnehmer 98 erfaßt. Der Hub des Pneumatikzylinders 97 drückt den auf der Plattform fixierten Transportbehälter mit seinem Behälterdeckel an den noch im schließenden Zustand befindlichen Verschluß 87. Der Verschluß 87 und der Behälterdeckel werden in der bereits beschriebenen Weise kraftschlüssig miteinander verbunden, die Verriegelungselemente im Behälterdeckel geöffnet.

Betätigt durch den Antrieb 94 wird die Trägerplatte 93 gemeinsam mit den darauf befestigten Elementen verschoben, so daß der Verschluß 87 gemeinsam mit dem Behälterdeckel aus der Beschickungsöffnung 83 entnommen wird. Angetrieben durch den Motor 90 wird der Verschluß 83 in eine Stellung gedreht, bei der die Beschickungsöffnung zum Umladen der scheibenförmigen Objekte frei wird. Diese Stellung entspricht der in der Fig. 18.

## Patentansprüche

1. Verfahren zum Be- und Entladen von Halbleitersubstratscheiben aus einem Transportbehälter in eine Bearbeitungsanlage - und umgekehrt, bei welchem
- ein zur Aüfnahme von gestapelten Substratscheiben (19) ausgebildeter Transportbehälter (6) mit einem lösbaren Seitendeckel (15) vor einer durch eine bewegbare Verschlußplatte (12) dicht verschlossenen Beschickungsöffnung (13) in einer Seitenwand (2) der Bearbeitungsanlage positioniert wird,
- ein Antriebsmechanismus für die Öffnungs- und Schließbewegung der Verschlußplatte (12) mit dem Seitendeckel (15) des zuvor positionierten Transportbehälters (6) gekoppelt wird,
- die Verschlußplatte (12) und der Seitendeckel (15) vom Antriebsmechanismus gemeinsam aus der Schließstellung in eine seitliche Öffnungsstellung - und umgekehrt - bewegt werden und
- Substratscheiben (19) durch einen Durchgriff einer Handhabungseinrichtung (22) durch die Beschickungsöffnung aus dem Transportbehälter (6) in die Bearbeitungsanlage - und umgekehrt - transportiert werden,
**dadurch gekennzeichnet, daß**
- der Transportbehälter (6) mit seinem Seitendeckel (15) in Anlage an die Verschlußplatte (12) gebracht und direkt mit der Verschlußplatte (12) gekoppelt wird
- der Seitendeckel (15) beim Öffnen des Transportbehälters (6) durch die Beschickungsöffnung (13) in der Seitenwand (2) hindurch in die innerhalb der Bearbeitungsanlage befindliche Öffnungsstellung bewegt wird und
- die Handhabungseinrichtung in der Bearbeitungsanlage angeordnet ist.

2. Halbleiten bearbeitungsanlage mit einer Vorrichtung zum Be- und Entladen der Halbleiterbearbeitungsanlage mit
- mindestens einer Beschickungsöffnung (13) in einer Seitenwand (2) der Bearbeitungsanlage,
- einer zwischen einer Schließstellung und einer seitlichen Offenstellung bewegbaren Verschlußplatte (12) zum Öffnen und Verschließen der Beschickungsöffnung (13),
- mindestens einem portablen Transportbehälter (6) für gestapelte Halbleitersubstratscheiben (19), der mit einem Seitendeckel (15) vor der Beschickungsöffnung (13) positionierbar ist,
- einem Antriebsmechanismus zum gemeinsamen und gleichzeitigen Öffnen bzw. Schließen der Verschlußplatte (12) und des Seitendeckels (15) und
- einer Handhabungseinrichtung (22) zum Erfassen und Übergeben der Substratscheibe (19) durch die Beschikkungsöffnung (13) hindurch,
**dadurch gekennzeichnet, daß**
- die Handhabungseinrichtung (22) in der Bearbeitungsanlage angeordnet ist und
- die Verschlußplatte (12) mittels Kopplungselementen (16, 61) direkt mit dem Seitendeckel (15) des positionierten Transportbehälters (6) kuppelbar und durch die Beschickungsöffnung (13) hindurch in die innerhalb der Bearbeitungsanlage befindliche Öffnungsstellung bewegbar ist.

3. Bearbeitungsanlage nach Anspruch 2, **dadurch gekennzeichnet, daß** eine horizontal verstellbare und mit Mitteln zum Ausrichten und Befestigen des Transportbehälters (6) versehene erste Plattform (7, 8) vorgesehen ist, worauf der Transportbehälter (6) zur Ankopplung an die Verschlußplatte (12) abstellbar ist.

4. Bearbeitungsanlage nach Anspruch 3, **dadurch gekennzeichnet, daß** die Plattform (7) zwischen mindestens zwei übereinanderliegenden Ebenen (9, 10) verstellbar ist, von denen eine (9) der Bestückung mit einem Transportbehälter (6) in einer ergonomischen Höhe und jede andere (10) zur Be- und Entladung dient.

5. Bearbeitungsanlage nach Anspruch 3 oder 4, **dadurch gekennzeichnet, daß** mehrere Plattformen (7, 8) zur Aufnahme von Transportbehältern (6) vorgesehen sind.

6. Bearbeitungsanlage nach Anspruch 5, **dadurch gekennzeichnet, daß** die Plattformen (7, 8 ) einzeln vor der Beschicküngsoffnüng (13) Ankopplung eines Transportbehälters (6) an die Verschlußplatte (12) positionierbar und die anderen Plattformen (7,8) zum Transportbehälterwechsel frei sind.

7. Bearbeitungsanlage nach einem der Ansprüche 3 bis 6, **dadurch gekennzeichnet, daß** zum Transportbehälterwechsel ein Speicher (44) vorgesehen ist, in dem ein Greifer (53) einen wahlfreien Zugriff in übereinander angeordnete Speicherfächer besitzt und eine Beladeöffnung (50) mit einer Transportbehälteraufnahme (52) zur manuellen Bestückung mit Transportbehältern (46) dient, und **daß** zum Umsetzen der Transportbehälter (46) zwischen der Transportbehälteraufnahme (52), den Speicherfächern (45) und der Plattform ein der Größe eines Transportbehälters entsprechender Raum (47) benachbart zu den Speicherfächern freigelassen ist.

8. Bearbeitungsanlage nach Anspruch 7, **dadurch gekennzeichnet, daß** die Transportbehälteraufnahme (52) zur Bestückung durch die Beladeöffnung (50) hindurch ausfahrbar ist.

9. Bearbeitüngsanlage nach einem der Ansprüche 2 bis 8, **dadurch gekennzeichnet, daß** die Verschlußplatte (12) zur Kopplung mit dem Behälterdeckel (15) Vakuumsauger (16) aufweist.

10. Bearbeitungsanlage nach einem der Ansprüche 2 - 9, **dadurch gekennzeichnet, daß** die Verschlußplatte (23) mit Elementen (60) zur Ausrichtung gegenüber dem Behälterdeckel (30) versehen ist.

11. Bearbeitungsanlage nach einem der Ansprüche 2 - 10 **dadurch gekennzeichnet, daß** zum Öffnen des Transportbehälters (6) an der Verschlußplatte (23) Schlüssel (61) zum Betätigen von Verriegelungselementen im Behälterdeckel (30) herausragen, für die im Behälterdeckel passende Schlüssellöcher(65) vorgesehen sind.

12. Bearbeitungsanlage nach Anspruch 10 mit 11, **dadurch gekennzeichnet, daß** die Ausrichtelemente (60) und die Schlüssel (61) zum Ausgleich von Differenzen bei der Annäherung zwischen der Verschlußplatte (25) und dem Behälterdeckel (30) in einer Richtung senkrecht zur Ebene der Umladung federnd gehaltert sind.

13. Bearbeitungsanlage nach einem der Ansprüche 2 bis 12, **dadurch gekennzeichnet, daß** die Beschickungsöffnung (13) in einem Schild (11) angeordnet ist, das gemeinsam mit dem angekoppelten Transportbehälter (6) zum Umladen der Substratscheiben (19) in Richtung senkrecht zur Ebene der Umladung nach indizierten Positionen gegenüber der Handhabungseinrichtung (22) verstellbar ist.

14. Bearbeitungsanlage nach einem der Ansprüche 2 bis 13, **dadurch gekennzeichnet, daß** die Handhabungseinrichtung (22) zum Umladen der Substratscheiben (19) in einer Richtung senkrecht zur Ebene der Umladung nach indizierten Positionen verstellbar ist.

## Claims

1. Method for transferring semiconductor substrate wafers from a transport container into a processing unit and vice-versa, wherein
a transport container (6) configured to receive stacked substrate wafers (19), with a detachable side cover (15), is positioned in front of a loading port (13) that is tightly closed by a movable shutter plate (12) in a side wall (2) of the processing unit,
a drive mechanism for the opening and closing movement of the shutter plate (12) is coupled to the side cover (15) of the transport container (6) thus positioned,
the shutter plate (12) and side cover (15) are moved together by the drive mechanism from the closed position to a laterally open position and vice-versa and
substrate wafers (19) are transferred out of the transport container (6) into the processing unit and vice-versa by a handling device (22) that reaches through the loading port,
**characterized in that**
the transport container (6) is shifted so that its side cover (15) is brought against the shutter plate (12) and is directly coupled to the shutter plate (12),
upon opening of the transport container (6) the side cover (15) is moved through the loading port (13) in the side wall (2) into the open position located within the processing unit and
the handling device is arranged inside the processing unit.

2. Semiconductor processing unit with an apparatus for loading and unloading the semiconductor processing unit with
at least one loading port (13) in a side wall (2) of the processing unit,
a shutter plate (12) movable between a closed position and a laterally open position so as to open and close the loading port (13),
at least one portable transport container (6) for stacked semiconductor substrate wafers (19) that is positionable with a side cover (15) in front of the loading port (13),
a drive mechanism for common and simultaneous opening, or closing, of the shutter plate (12) and side cover (15) and
a handling device (22) for seizing and transferring the substrate wafer (19) through the loading port (13),
**characterized in that**
the handling device (22) is arranged inside the processing unit and
the shutter plate (12) is directly connectable by means of coupling elements (16, 61) to the side cover (15) of the positioned transport container (6) and movable through the loading port (13) into the open position located within the processing unit.

3. Processing unit according to Claim 2, **characterized in that** a horizontally displaceable first platform (7, 8) is provided on which the transport container (6) can be put for coupling to the shutter plate (12) and which is provided with means for aligning and securing the transport container (6).

4. Processing unit according to Claim 3, **characterized in that** the platform (7) is displaceable between at least two planes (9, 10) located one above the other, one (9) of which is for loading with a transport container (6) at an ergonomic height, and the, or each, other (10) of which is for the transfer of substrate wafers.

5. Processing unit according to Claim 3 or Claim 4, **characterized in that** a plurality of platforms (7, 8) for receiving transport containers (6) are provided.

6. Processing unit according to Claim 5, **characterized in that** the platforms (7, 8) are individually positionable in front of the loading port (13) for coupling of a transport container (6) to the shutter plate (12), and the other platforms (7, 8) are available for exchange of transport containers.

7. Processing unit according to any one of Claims 3 to 6, **characterized in that** a storage unit (44) is provided for the exchange of transport containers, in which a gripper (53) has free-ranging access to storage compartments arranged one above the other and a loading port (50) with a transport container receptacle (52) is used for manual loading with transport containers (46), and **in that** adjacent to the storage compartments a space (47) corresponding to the size of a transport container (46) is left clear for the movement of transport containers (46) between the transport container receptacle (52), the storage compartments (45) and the platform.

8. Processing unit according to Claim 7, **characterized in that** the transport container receptacle (52) is retractable for loading through the loading port (50).

9. Processing unit according to any one of Claims 2 to 8, **characterized in that** the shutter plate (12) has vacuum suckers (16) for coupling to the container cover (15).

10. Processing unit according to any one of Claims 2 to 9, **characterized in that** the shutter plate (23) is provided with elements (60) for aligning with the container cover (30).

11. Processing unit according to any one of Claims 2 to 10, **characterized in that**, to open the transport container (6), keys (61), for which matching keyholes (65) are provided in the container cover (30), project from the shutter plate (23) to actuate locking elements inside the container cover (30).

12. Processing unit according to Claim 10 with Claim 11, **characterized in that** the aligning elements (60) and keys (61) are mounted elastically in a direction perpendicular to the plane of transfer in order to compensate for differences in approach between the shutter plate (25) and the container cover (30).

13. Processing unit according to any one of Claims 2 to 12, **characterized in that** the loading port (13) is arranged in a shield (11) that is displaceable together with the coupled transport container (6) in a direction perpendicular to the plane of transfer to indexed positions with respect to the handling device (22) for the transfer of substrate wafers (19).

14. Processing unit according to any one of Claims 2 to 13, **characterized in that** the handling device (22) is displaceable in a direction perpendicular to the plane of transfer to indexed positions for the transfer of substrate wafers (19).

## Revendications

1. Procédé de chargement et de déchargement de tranches de substrats de semi-conducteurs à partir d'un conteneur de transport dans une installation de traitement et inversement, procédé dans lequel
- un conteneur de transport (6) réalisé pour recueillir des tranches empilées de substrat (19), avec un couvercle latéral (15) détachable est positionné devant une ouverture de chargement (13) fermée hermétiquement par une plaque d'obturation mobile (12) dans une paroi latérale (2) de l'installation de traitement,
- un mécanisme d'entraînement pour le mouvement d'ouverture et de fermeture de la plaque d'obturation (12) est couplé avec le couvercle latéral (15) du conteneur de transport (6) positionné au préalable,
- la plaque d'obturation (12) et le couvercle latéral (15) se déplacent ensemble, par le biais du mécanisme d'entraînement, hors de la position de fermeture en une position d'ouverture latérale, et inversement et
- les tranches de substrat (19) sont transportées hors du conteneur de transport (6) vers l'installation de traitement et inversement par intervention d'un dispositif de manipulation (22) à travers l'ouverture de chargement,
**caractérisé en ce que**
- le conteneur de transport (6) avec son couvercle latéral (15) est mis contre la plaque d'obturation (12) et est directement couplé avec la plaque d'obturation (12)
- lors de l'ouverture du conteneur de transport (6), le couvercle latéral (15) est déplacé à travers l'ouverture de chargement (13) dans la paroi latérale (2) en position d'ouverture se trouvant à l'intérieur de l'installation de traitement et le dispositif de manipulation est disposé dans l'installation de traitement.

2. Installation de traitement de semi-conducteurs avec un dispositif de chargement et de déchargement de l'installation de traitement des semi-conducteurs avec
- au moins une ouverture de chargement (13) dans une paroi latérale (2) de l'installation de traitement,
- une plaque d'obturation (12) mobile entre une position de fermeture et une position d'ouverture latérale pour ouvrir et fermer l'ouverture de chargement (13),
- au moins un conteneur de transport portatif (6) pour des tranches empilées de substrat de semi-conducteurs (19), container qui est positionnable avec un couvercle latéral (15) devant l'ouverture de chargement (13),
- un mécanisme d'entraînement pour l'ouverture et/ou la fermeture commune et simultanée de la plaque d'obturation (12) et du couvercle latéral (15) et
- un dispositif de manipulation (22) pour saisir et remettre la tranche de substrat (19) à travers l'ouverture de chargement (13), **caractérisée en ce que**
- le dispositif de manipulation (22) est disposé dans l'installation de traitement et **en ce que**
- la plaque d'obturation (12) peut être directement couplée au moyen d'éléments de couplage (16, 61) avec le couvercle latéral (15) du conteneur de transport positionnable (6), et peut être déplacée à travers l'ouverture de chargement (13) dans la position d'ouverture se trouvant à l'intérieur de l'installation de traitement.

3. Installation de traitement selon la revendication 2, **caractérisée en ce qu'**une première plateforme (7, 8) réglable horizontalement et pourvue d'éléments pour ajuster et fixer le conteneur de transport (6) est prévue, sur laquelle le conteneur de transport (6) peut être ajusté pour le couplage à la plaque d'obturation (12).

4. Installation de traitement selon la revendication 3, **caractérisée en ce que** la plateforme (7) est réglable entre au moins deux niveaux superposés (9, 10) dont l'un (9) sert au garnissage à une hauteur ergonomique d'un conteneur de transport (6) et chaque autre (10) sert au chargement et au déchargement.

5. Installation de traitement selon la revendication 3 ou 4, **caractérisée en ce que** plusieurs plateformes (7, 8) sont prévues pour recueillir les conteneurs de transport (6).

6. Installation de traitement selon la revendication 5, **caractérisée en ce que** les plateformes (7, δ) sont chacune positionnables devant l'ouverture de chargement (13) pour coupler un conteneur de transport (6) à la plaque d'obturation (12) et les autres plateformes (7, 8) sont libres pour le changement des conteneurs de transport.

7. Installation de traitement selon l'une des revendications 3 à 6, **caractérisée en ce qu'**un espace de stockage (44) est prévu pour le changement des conteneurs de transport, dans laquelle un grappin (53) a un accès sélectif dans les compartiments de l'unité de stockage disposés les uns sur les autres, et une ouverture de chargement (50) avec une réception (52) de conteneurs de transport sert au garnissage manuel des conteneurs de transport (46), et **en ce qu'**un espace (47) correspondant à la taille d'un conteneur de transport, contigu aux compartiments de stockage est laissé libre pour déplacer les conteneurs de transport (46) entre la réception (52) de conteneurs de transport, les compartiments de stockage (45) et la plateforme.

8. Installation de traitement selon la revendication 7, **caractérisée en ce que** la réception de conteneurs de transport (52) est télescopique à travers l'ouverture de chargement (50) en vue d'un garnissage.

9. Installation de traitement selon l'une des revendications 2 à 8, **caractérisée en ce que** la plaque d'obturation (12) comporte des aspirateurs à vide (16) pour le couplage avec le couvercle du conteneur (15).

10. Installation de traitement selon l'une des revendications 2 à 9, **caractérisée en ce que** la plaque d'obturation (23) est pourvue d'éléments (60) pour un ajustage par rapport au couvercle du conteneur (30).

11. Installation de traitement selon l'une des revendications 2 à 10, **caractérisée en ce qu'**en vue d'ouvrir le conteneur de transport (6) sur la plaque d'obturation (23), des clés (61) font saillie pour actionner les éléments de verrouillage dans le couvercle du conteneur (30), pour lesquelles des trous de serrure correspondants (65) sont prévus dans le couvercle du conteneur.

12. Installation de traitement selon la revendication 10 avec 11, **caractérisée en ce que**, pour compenser les différences lors du rapprochement entre la plaque d'obturation (25) et le couvercle du conteneur (30), les éléments d'ajustage (60) et les clés (61) sont fixés de manière élastique dans un sens perpendiculaire au niveau du transbordement.

13. Installation de traitement selon l'une des revendications 2 à 12, **caractérisée en ce que** l'ouverture de chargement (13) est disposée dans un panneau (11) qui est réglable conjointement avec le conteneur de transport couplé (6) pour transborder les tranches de substrat (19) dans le sens perpendiculaire au niveau du transbordement selon les positions indiquées par rapport au dispositif de manipulation (22).

14. Installation de traitement selon l'une des revendications 2 à 13, **caractérisée en ce que** le dispositif de manipulation (22) est réglable pour transborder les tranches de substrat (19) dans un sens perpendiculaire au niveau du transbordement selon les positions indiquées.
